# EUROPEAN PATENT SPECIFICATION

(11) **EP 1 014 683 B1**
(45) Date of publication and mention of the grant of the patent: **11.10.2006**
(21) Application number: 99310055.1
(22) Date of filing: 14.12.1999
(51) Int. Cl.: H04N 1/195

(54) **Image pickup apparatus**
Bildaufnahmegerät
Appareil de prise d'image

(30) Priority: 15.12.1998 JP 35626898
(43) Date of publication of application: 28.06.2000
(73) Proprietor: CANON KABUSHIKI KAISHA, Tokyo (JP)
(72) Inventor: Hashimoto, Seiji, Ohta-ku, Tokyo (JP)
(74) Representative: Beresford, Keith Denis Lewis

(56) References cited:
- EP-A2- 0 762 504
- WO-A-97/01238
- DE-A- 4 329 259
- DE-A- 19 524 858
- US-A- 5 493 423
- US-A- 5 773 832
- SETO T ET AL: "PERFORMANCE OF 1M-IRCSD IMAGER WITH PTSI SCHOTTKY-BARRIER DETECTORS" PROCEEDINGS OF THE SPIE, SPIE, BELLINGHAM, VA, US, vol. 2020, 1993, pages 404-414, XP002071024

## Description

The present invention relates to an image pickup apparatus such as can be used in a digital camera system, a system for reading an image in a digital copying machine, or a digital X-ray imaging systems.

In an image reading system, a reduction optical type sensor using a CCD, a sensor having an amplifier for amplifying charges accumulated in a photoelectric converting area in pixels, or an equal magnification type CIS sensor using a-Si (amorphous silicon), etc. are conventionally used as a line sensor. A CCD having high sensitivity characteristics mainly is used in a video camera and a digital still camera as an area sensor in which the pixels are two-dimensionally arranged. A CMOS sensor having high sensitivity characteristics equal to those of the CCD type attracts public attention as a high sensitivity sensor.

In contrast to this, an X-ray image pickup apparatus for converting an incident X-ray to light by a scintillator and further detecting such light by a sensor is researched and developed in a medical treatment field, a non-destructive inspecting field, etc. For example, a compact CCD is practically used for dentistry in the medical treatment field. Further, the amorphous silicon (a-Si) and a pin type photodiode, etc. are recently researched and developed in a large-sized X-ray image pickup apparatus having a size of several tens cm or more in chest photographing, etc.

An improvement example of the a-Si type is disclosed in Japanese Patent Application Laid-Open No. 9-135013, and European Patent Application No. EP-A-0762504. This image pickup apparatus is large-sized and can cheaply obtain a still image.

A motion image pickup apparatus of the next generation to a still image pickup apparatus is expected as the image pickup apparatus, particularly, an image pickup apparatus used in an X-ray image pickup sensor used in the medical treatment field.

Here, there are (1) high sensitivity and high speed reading techniques, (2) large-sized structure, (3) low cost, etc. as technical problems.

With respect to the above problems of the high sensitivity and high speed reading techniques, high sensitivity and reading speed ten times or more are required in comparison with the present a-Si and the pin type to pick up a motion image. An X-ray is continuously irradiated to a human being to pick up the motion image. However, in consideration of influences due to the X-ray irradiation, it is necessary to reduce an irradiation amount of the X-ray to 1/several and sensitivity corresponding to an exposure time of 1/several and a high speed several times are required to perform an image reading operation of several tens frames/second. In this respect, it is difficult to realize this requirement in the a-Si and the pin type photodiode.

The CCD of a perfect depletion type certainly has high sensitivity, but becomes unsuitable as a chip size is increased. Since the CCD is of a charge transfer type, a transfer becomes a problem as the number of transfer stages (high pixels) is increased. Namely, a driving voltage at a driving end of the CCD is different from that near a centre of the CCD so that it is difficult to perform a perfect transfer operation. Power consumption is expressed by CV²f, but C and V are increased as an area of the CCD is increased. Accordingly, a peripheral driving circuit becomes a heating source and a noise source so that no high S/N is obtained. Therefore, the CCD has one aspect unsuitable for a large-sized sensor.

A manufacturing process of the large-sized sensor in the a-Si and the pin type is advantageous in comparison with the CCD and the CMOS sensor. However, no photoelectric converting portion is of a perfect depletion type and there is a KTC noise depending on the parasitic capacity of an output line and sensitivity is low. Further, a driving circuit of the sensor and an amplifier are externally required (see: Fig. 1 of Japanese Patent Application Laid-Open No. 9-135013; Fig. 3 of EP-A-0762504) and it is necessary to make a good quality article judgement of the sensor after peripheral parts are assembled in the sensor. Therefore, price of the sensor itself is relatively low, but final cost is high.

The present invention concerns an image pickup apparatus of the kind comprising:
image pickup areas arranged two-dimensionally in a first direction and a second direction, different from the first direction on respective semiconductor substrates, each of said image pickup areas including pixels arranged in the first direction and in the second direction wherein image pickup areas in which the pixels are connected to each vertical signal line on the unit basis of a plurality of pixels arranged in the first direction, and each of said pixels including a photodiode and a pixel amplifier for holding a signal from the photodiode at a floating diffusion portion of the pixel amplifier and amplifying the signal;
first scanning circuits arranged to reset-scan the floating diffusion portion of the pixel amplifier on a unit basis of the plurality of pixels arranged in the second direction andread-scan the pixels so as to read out signals to the vertical signal lines on the unit basis of the plurality of pixels arranged in the second direction, wherein said first scanning circuits effect in parallel the reset scanning and read scanning of each plurality of image pickup areas arranged in the first direction;
a memory circuit arranged to hold signals from once line of pixels arranged in the second direction; and
second scanning circuits arranged to sequentially read out the signals held in said memory circuit to an output line, wherein said second scanning circuits scan in parallel the plurality of image pickup areas arranged in the second direction, to read out the signals held in said memory circuit.

The present invention is intended to provide an image pickup apparatus, capable of obtaining an image, especially a motion image, of good quality.

In the image pickup apparatus, in accordance with the present invention, said first scanning circuit is arranged so as to reset-scan the image pickup areas on the respective semiconductor substrates which are arranged adjacently to each other in the first direction, in opposite directions to reset the floating diffusion portion of the pixel amplifier of the pixels included therein, and read-scan the image pickup areas on the respective semiconductor substrates, which are arranged adjacently to each other in the first direction, in opposite directions to read out the pixels included therein.

Other advantages and features of the present invention and of its preferred embodiments will become apparent from the following particular description and drawings, wherein:
Fig. 1 is a view showing the schematic construction of an image pickup apparatus when four image pickup sensors are stuck to each other;
Fig. 2 is an explanatory view of a scanning method of the image pickup apparatus of Fig. 1;
Fig. 3 is a view showing constructions of one pixel portion of an image pickup area of the image pickup apparatus of Fig. 1 and its signal read-out circuit;
Fig. 4 is a view for explaining a case in which scanning directions of a row scanning circuit are set to the same direction in the sticking image pickup apparatus;
Fig. 5 is a timing diagram for explaining row scanning of the image pickup apparatus;
Fig. 6 is a timing chart showing a read-out operation of a pixel signal and a noise signal of the image pickup apparatus;
Fig. 7 is an explanatory view showing a read-out system of the image pickup apparatus;
Fig. 8 is a conceptual view in which upper and lower (left-hand and right-hand) sensors are formed in the same form;
Fig. 9 is a view showing an entire construction of the image pickup apparatus as one embodiment;
Fig. 10 is a typical constructional view of a mounting example of the image pickup apparatus;
Fig. 11 is a view showing a schematic flow of taking-in of data from rising setting of the apparatus, and processing and display of the data;
Fig. 12 is a typical view showing a further concrete example of an X-ray diagnostic system using the image pickup apparatus in one embodiment of the present invention;
Fig. 13 is an explanatory view showing a case in which sixteen image pickup sensors are stuck to each other;
Figs. 14A and 14B are explanatory views showing another embodiment of the image pickup apparatus; and
Figs. 15A, 15B and 15C are explanatory views showing another embodiment of the image pickup apparatus.

### DESCRIPTION OF THE PREFERRED EMBODIMENTS

Embodiments of the present invention will next be explained in detail by using the drawings.

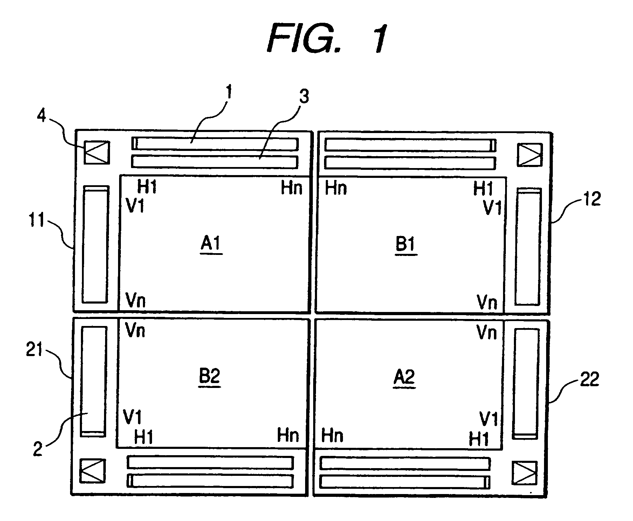

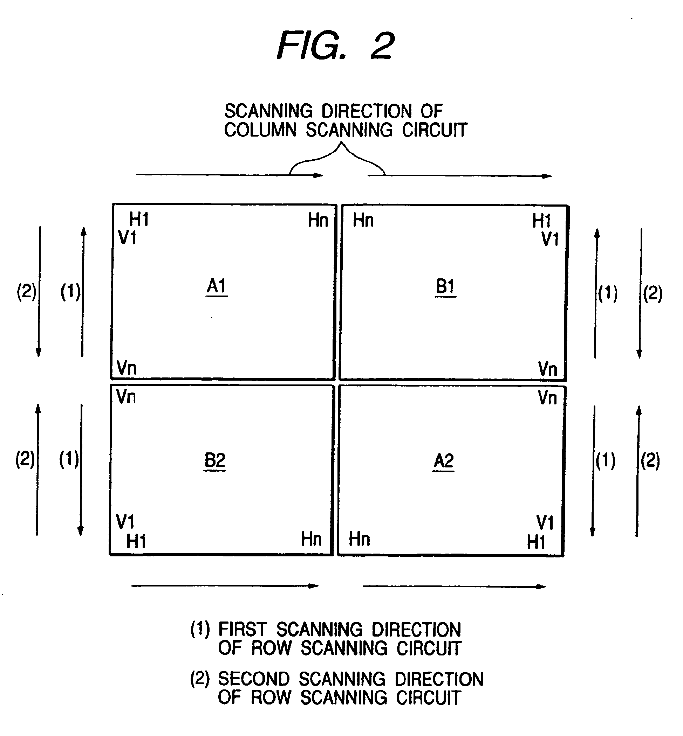

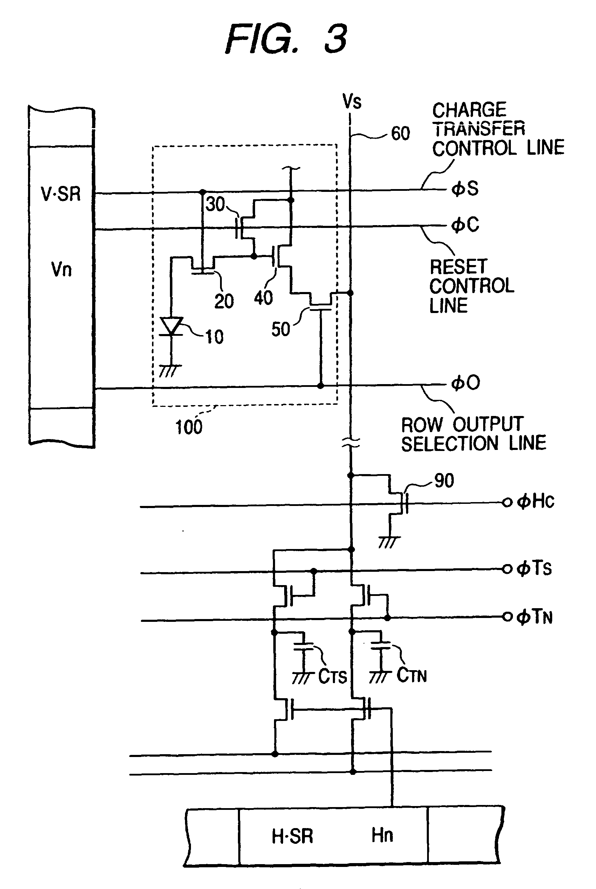

Fig. 1 is a view showing the schematic construction of an image pickup apparatus in which four image pickup sensors are stuck to each other. Fig. 2 is an explanatory view of a scanning method of the image pickup apparatus of Fig. 1. Fig. 3 is a view showing constructions of one pixel portion of an image pickup area of the image pickup apparatus of Fig. 1 and its signal read-out circuit. The present invention is not limited to the image pickup apparatus in which plural image pickup sensor boards respectively having image pickup areas are stuck to each other, but can be also applied to an image pickup apparatus in which plural image pickup areas and a scanning circuit, etc. are formed in one semiconductor board. Further, the present invention is not limited to a case in which the four image pickup sensors are stuck to each other, but can be also applied to an image pickup apparatus in which two image pickup sensors or more for performing a scanning operation in a row direction are stuck to each other (or an image pickup apparatus having two image pickup areas or more for performing the scanning operation in the row direction). Further, no pixel construction of the image pickup apparatus of the present invention is particularly limited to a CMOS sensor described later. The above "first arranging direction" is equal to a scanning direction of a row scanning circuit of Fig. 1 and the "second arranging direction" is equal to a scanning direction of a column scanning circuit.

In Fig. 1, reference numerals 11 and 22 and reference numerals 12 and 21 denote image pickup sensors in the same form stuck to each other such that the image pickup sensors 11 and 22 and the image pickup sensors 12 and 21 are diagonally arranged on the same board. The four image pickup sensors 11, 12, 21 and 22 are stuck to each other such that a scanning circuit and an output circuit (a memory circuit, etc.) are arranged on an outer side (a peripheral side). Reference characters A1, A2, B1 and B2 respectively denote image pickup areas of the image pickup sensors 11, 22, 12 and 21.

The construction of the image pickup sensor 11 as an example will next be explained.

The image pickup area A1 of the image pickup sensor 11 is constructed by arranging plural pixel portions 100 of Fig. 3 described later in horizontal and vertical directions. Pitches of the pixel portions 100 are different from each other in accordance with applications. When the image pickup sensor is applied to a chest portion image pickup apparatus of a human being using an X-ray, about 15 cm in square size and 50 µm to 100 µm in resolution are required in the image pickup area A1. In this embodiment, the explanation is made when the pitch of the pixel portions is 50 µm.

It is relatively easy to construct pixels having 50 µm in pitch by CMOS sensors as shown by the pixel portions 100. Namely, the CMOS sensors are developed and produced such that a pitch of the CMOS sensors ranges from 5 µm to 10 µm.

Since the pixel size is large in this embodiment, no problem is caused even when a semiconductor device MPA (Mirror Projection Aligner) of a one-to-one optical system is used.

An image pickup sensor having a size a little more than 15 cm can be manufactured by a 20 cm (8-inch) wafer. Further, an image pickup sensor having a larger image pickup area and 20 cm in size can be sufficiently manufactured by a 30 cm (12-inch) wafer which seems to be the mainstream of a semiconductor in the future. When the image pickup area is set to a square size of 15 cm and the pixel pitch is set to 75 µm, the number of pixels of the image pickup sensor is 2,000 × 2,000 = 4,000,000 four millions.

A row scanning circuit (V-SR) 2 is arranged on one side of the image pickup area A1 and a pixel row is selected by this row scanning circuit 2 in the vertical direction. Further, a memory circuit 3, an unillustrated transistor circuit, reset circuit (not shown) and a column scanning circuit (H-SR) 1 are arranged on another side of the image pickup area A1. The memory circuit 3 temporarily holds a signal in the pixel row selected by the row scanning circuit 2. The transistor circuit controls the operation of an amplifier of pixels in an active state. The reset circuit resets a residual signal of a vertical signal line. The column scanning circuit (H-SR) 1 controls read-out of the signal from the memory circuit 3.

Light-shielding for clamping a black signal is made with respect to predetermined pixels (e.g., several ten pixels) on the face on which the image pickup area A1 is adjacent to the scanning circuits 1, 2.

An output of the memory circuit 3 is connected to an output amplifier 4 in which signal amplification and impedance conversion are performed. In the image pickup sensor in this embodiment, each pixel portion is formed by a photodiode and a CMOS amplifier, and the memory circuit is formed by a capacitor and the scanning circuit is formed by a CMOS transistor and the output amplifier is also formed by a CMOS transistor.

Since the constructional portions except for the photodiode are constructed by CMOS structure as mentioned above, the amplifier, an A/D converting circuit, a SRAM, etc. can be built in the pixel portion. Since the column scanning circuit 1 is operated by a driving method explained with reference to Fig. 2, the column scanning circuit 1 is constructed by a circuit capable of performing a bidirectional driving operation. However, since it is not necessary to particularly limit a scanning direction of the column scanning circuit as described later, no column scanning circuit may be constructed by a circuit capable of performing the bidirectional driving operation.

One example of the scanning method suitably used in the above image pickup apparatus will next be explained by using Fig. 2. This scanning method can be suitably used to pick up a motion image, but can be also used to pick up a still image naturally.

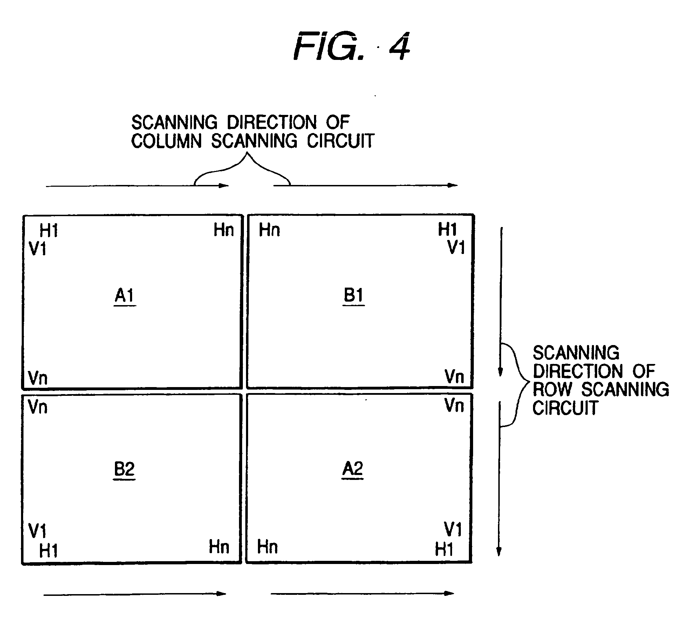

When the image of a moving object is picked up by the image pickup apparatus having plural image pickup sensors stuck to each other, joint in the connection of the motion images between the image pickup sensors becomes important. This embodiment will next be explained when four images are synthesized as an example. When four image pickup sensors are separately independently operated in a scanning direction shown in Fig. 4, correlation of the images is lost in joint portions of four screens (a joint portion of image pickup areas A1 and B2, a joint portion of image pickup areas B1 and A2, a joint portion of image pickup areas A1 and B1, and a joint portion of image pickup areas B2 and A2). For example, a shift in time is caused by a scanning period in a row direction in a pixel row (a pixel row for terminating scanning) of the image pickup area A1 and a pixel row (a pixel row for starting scanning) of the image pickup area B2 which are adjacent in the vicinity of the joint portion of the image pickup areas A1 and B2. Accordingly, the correlation of the images is lost.

Since the number of pixels is small in the case of a television image, necessity of sticking is small and it is possible to set a frame frequency to range from 60 Hz to 600 Hz if necessary. However, since the image pickup apparatus of this embodiment is constructed by 4 x 4,000,000 pixels, it is necessary to perform a superhigh speed driving operation by continuously performing the scanning operation using four image pickup apparatuses in a similar way. It is difficult to realize such a superhigh speed driving operation. For example, when 16,000,000 pixels are read at a rate of 30 frames/second, the frame frequency becomes 1,600 × 10⁴ × 30 = 0.48 × 10⁹ so that the frame frequency becomes about 480 MHz. It should be understood that it is difficult to realize the continuous scanning operation even when no large screen having a square size of 15 cm × 4 is used. In the present invention, to enable 30 frames/second, a driving frequency is reduced to about 15 MHz which is 1/32 of 480 MHz(actually becomes about 20 MHz by a reset time of pixels, signal transfer from the pixels, etc.) by
(1) frequency is reduced to 1/4 by operating the four image pickup sensors in parallel with each other, and
(2) frequency is reduced to 1/8 with one image pickup sensor as an 8-line output.

With respect to the problem of the correlation of the above images, scanning directions of the row scanning circuit are not set to the same direction as shown in Fig. 4, but are set to directions opposed to each other as shown in Fig. 2 with respect to adjacent image pickup sensors in this embodiment. As shown in Fig. 2, if the scanning operation of the row scanning circuit is performed in directions opposed to each other between the adjacent image pickup sensors, a scanning operation (a scanning direction of reference numeral (1) in Fig. 2) separated from sticking sides of the image pickup sensors and a scanning operation (a scanning direction of reference numeral (2) in Fig. 2) approaching these sticking sides may be performed.

Since the four image pickup sensors are operated in parallel with each other in the image pickup apparatus of this embodiment, the "joint" of a motion image at a time of this operation becomes a matter of concern basically in image pickup areas A1 and B1, image pickup areas A1 and B2, image pickup areas B2 and A2, and image pickup areas B1 and A2 for jointing images to each other. However, as shown in Fig. 2, only the scanning directions of the row scanning circuit are set to opposite directions in this embodiment. As explained later, this is because image pickup areas A1 and B2 and image pickup areas B1 and A2 are more important in comparison with image pickup areas A1 and B1 and image pickup areas B2 and A2.

As shown in Fig. 4, when image pickup areas A1 and B1 are row-scanned in parallel from V1 to Vn of the row scanning circuit and image pickup areas B2 and A2 are row-scanned in parallel from Vn to V1 of the row scanning circuit, a shift in exposure time is caused for a 1V period in the joint portion of image pickup areas A1 and B2 and the joint portion of image pickup areas B1 and A2. In this embodiment, as shown in Fig. 2, the row scanning operation is performed in parallel from Vn to V1 ((1) of Fig. 2), or is performed in parallel from V1 to Vn ((2) of Fig. 2) by each of the image pickup sensors such that a pixel shift in image pickup areas close to each other in space as in image pickup areas A1 and B2 and image pickup areas B1 and A2 is removed or is further reduced. Thus, an image shift can be removed or further reduced in the joints of image pickup areas A1 and B2 and image pickup areas B1 and A2.

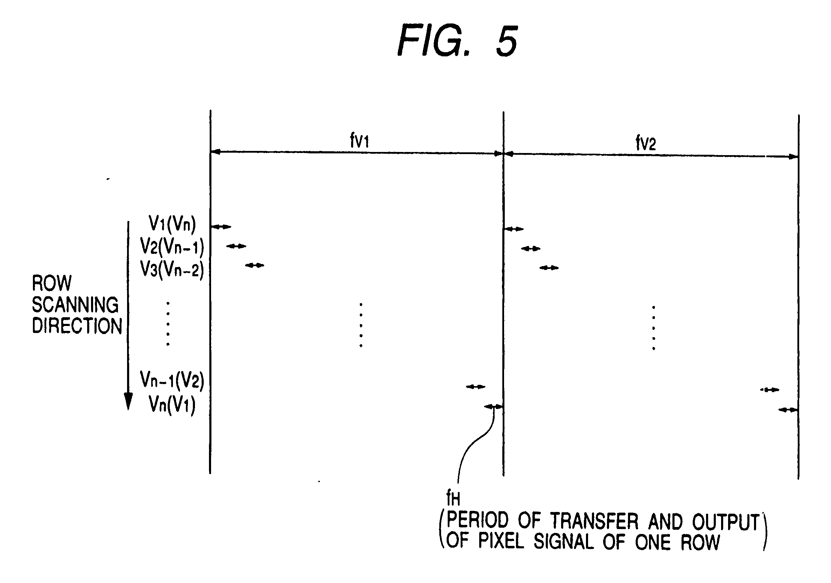

Fig. 5 shows an explanatory view of timing of row scanning. In Fig. 5, fv is set to 30 Hz and fH is set to about 16.7 µs since there are about 2,000 rows. Pixel signals in one row are transferred and outputted within the period of fH. If the pixel signals are transferred and outputted in the same timing in the scanning direction from the joint portions of image pickup areas A1 and B2 and image pickup areas B1 and A2, accumulating timings of pixels in a pixel row of the same number in the scanning direction are the same since the pixel signals are transferred and outputted in the same period.

Column scanning will next be explained. Similar to the row scanning, a problem of the "joint" of a motion image also exists in the joint portions of image pickup areas A1 and B1 and image pickup areas B2 and A2. However, an exposure time shift in this scanning direction is 16.7 µs at its maximum and this time shift is substantially of no importance. Therefore, it is not necessary to perform a scanning operation in a reverse direction similar to that in the column scanning. Accordingly, the scanning operation may be essentially performed from one of H1 or Hn.

In this embodiment, image pickup area A1 (or image pickup area B2) is scanned from H1 to Hn and image pickup area B1 (or image pickup area A2) is scanned from Hn to H1 so as to similarly gain access to a memory. Therefore, the column scanning circuit is constructed by a bidirectional shift register.

As described above, since the present invention includes scanning means for scanning a plurality of image pickup areas so that accumulation timings of pixels of adjacent image pickup areas become equal to each other, the problem caused by the joint in the connection of the image pickup areas can be solved.

Fig. 3 is a view showing the schematic construction of an image pickup sensor. In Fig. 3, H-SR denotes a column scanning circuit, V-SR denotes a row scanning circuit and a block 100 is a unit pixel. CTS and CTN denote capacitors for a memory for temporarily holding a pixel signal and a pixel noise. In an output of this memory, the pixel noise is removed from the pixel signal by a differential amplifier at a subsequent stage and an unillustrated signal having a good SN ratio is outputted.

In the unit pixel 100, reference numerals 10 and 20 respectively denote a photodiode and a transfer switch for transferring a signal photoelectrically converted from the photodiode 10 to a floating diffusion portion (an FD portion) of a pixel amplifier. Reference numerals 30, 40 and 50 respectively denote a reset switch for resetting an electric potential of the FD portion of the pixel amplifier to a reset electric potential, the pixel amplifier and a pixel (row unit) selection switch connected to the pixel amplifier 40. There is a load of the pixel amplifier 40 on a vertical signal line vs (omitted in Fig. 3) and reference numeral 90 denotes a clear switch for clearing residual charges on the vertical signal line Vs.

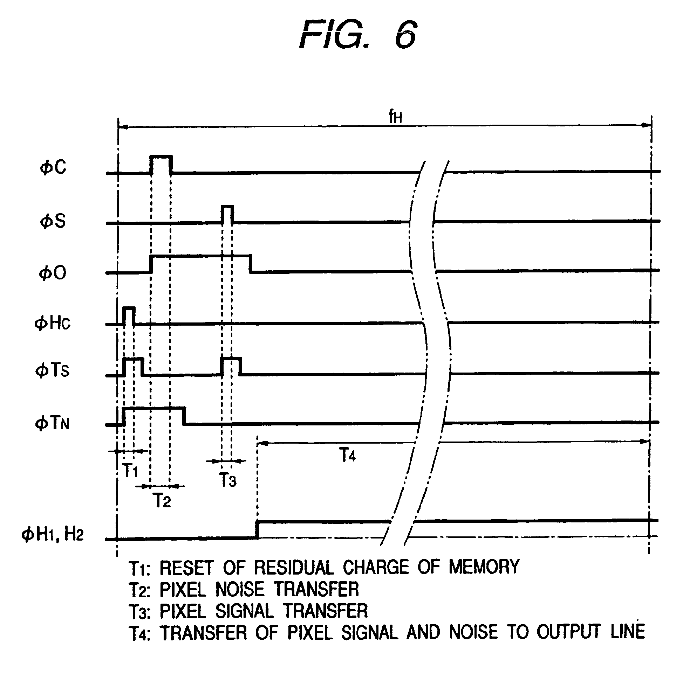

Fig. 6 is a timing chart of the column scanning. In Fig. 6, reference characters T1, T2, T3 and T4 respectively denote a residual charge reset period of a memory, a pixel noise transfer period, a pixel signal transfer period, and an output period of a pixel signal and a noise.

In the period T1, signals φHC, φTS and φTN attain high voltage levels, and the clear switch 90 and switches between the vertical signal line and capacitors CTS, CTN are turned on, and a vertical signal line 60 and the capacitors CTS, CTN are reset.

Next, in the period T2, signals φc, φo and φTN attain high voltage levels and the reset switch 30 is turned on and the FD portion is reset. After the FD portion is reset, the noise signal is transferred to the capacitor CTN.

Next, in the period T3, signals φs, φo and φTS attain high voltage levels so that the pixel signal from the photodiode 10 is transferred to the capacitor CTS.

Next, in the period T4, a scanning operation using the column scanning circuit H-SR is sequentially performed by signals H1, H2 inputted to the column scanning circuitH-SR so that the pixel signal and the noise signal are simultaneously transferred to each output line.

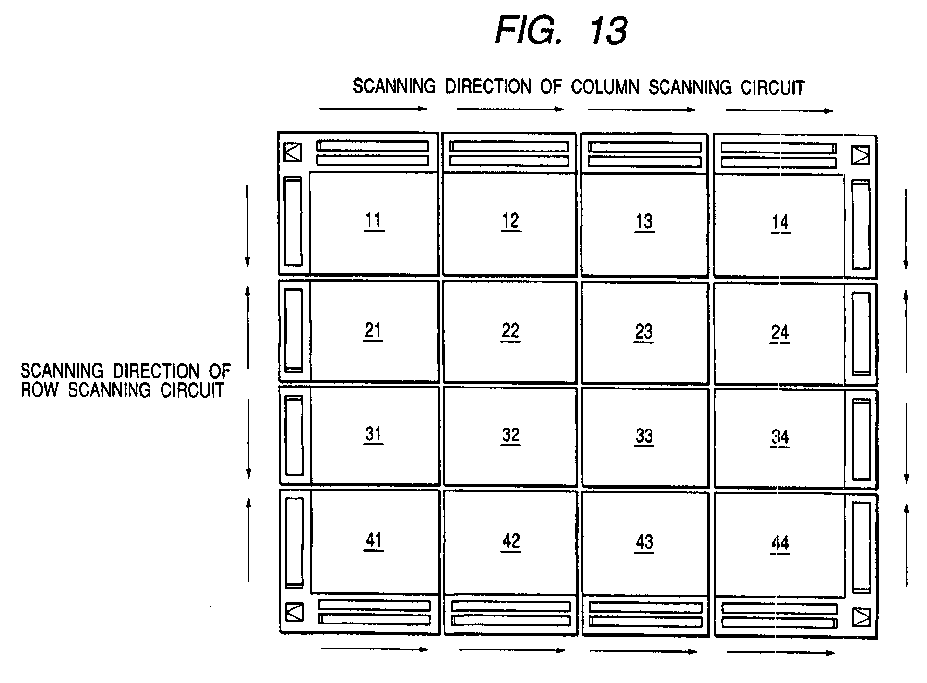

As already explained, the present invention is not limited to a case in which four image pickup sensors are stuck to each other. Fig. 13 shows an embodiment in which sixteen image pickup sensors are stuck to each other. The image pickup sensors are electrically connected to each other except for image pickup sensors 21 and 31, 22 and 32, 23 and 33, and 24 and 34. Column and row scanning operations of pixels in each of stuck image pickup areas are performed. In this arrangement, image pickup sensors 11 and 44, 14 and 41, 21 and 34, 24 and 31, 22, 23, 32, 33 can be formed in the same form. Further, if a bidirectional shift register is used in the column scanning circuit, image pickup sensors 12, 13, 42, 43 can be also formed in the same form.

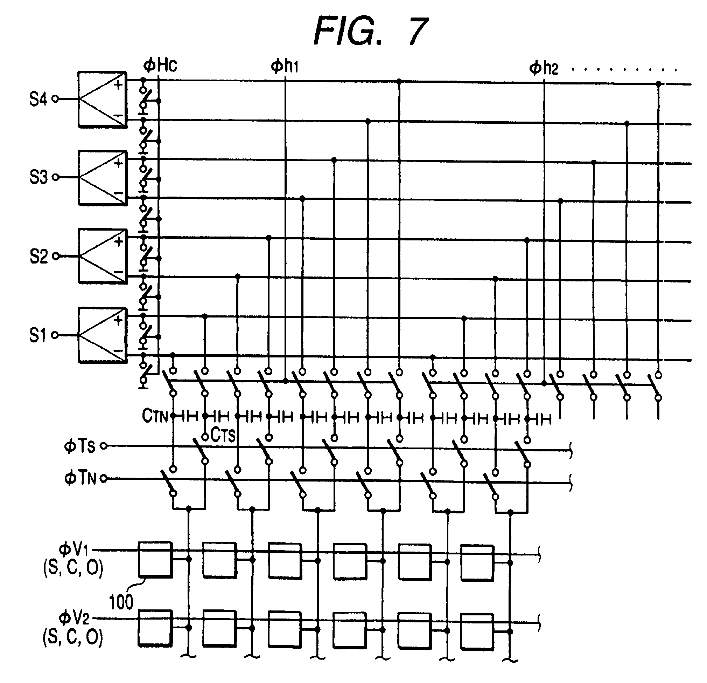

Fig. 7 shows an embodiment of divisional parallel transfer of a memory signal. In this embodiment, the 8-line output is performed to reduce a transfer frequency, but a construction in the case of a 4-line output is here shown to simplify the explanation. The 8-line output can be achieved by setting output lines subsequent to the memory to eight lines and connecting these eight lines and increasing the number of output amplifiers. As shown in Fig. 7, a signal and a noise of the memory accumulated to each of the capacitors CTS, CTN are respectively transferred to a noise output line and a signal output line by a pulse (φh1, φh2, ---, φhn) of the column scanning circuit every four columns of pixels. Further, subtracting processing of (signal-noise) is performed by a subtracting output amplifier connected to the noise output line and the signal output line so that a signal with its noise component removed therefrom is outputted (S1 - S4).

When the orientations of read-out scanning directions of adjacent image pickup sensors are set to be opposite in the adjacent image pickup sensors, it is desirable to form image pickup sensors diagonally arranged in the same form as shown in Figs. 1 and 2 in the image pickup apparatus having four image pickup sensors stuck to each other.

Namely, as shown in Fig. 1, if image pickup sensors 11 and 22 and image pickup sensors 12 and 21 are formed in the same form, image pickup sensors 11 and 22 and image pickup sensors 12 and 21 can be manufactured by the same mask. Mask management, test, semiconductor manufacturing management, stock management, apparatus for sticking, etc. are facilitated by constructing the image pickup apparatus by two kinds of image pickup sensors so that the number of defective products and cost can be reduced. It is possible to cope with masks used in manufacturing processes of image pickup sensors 11, 22 and image pickup sensors 12, 21 by mirror inversion so that design burden is reduced.

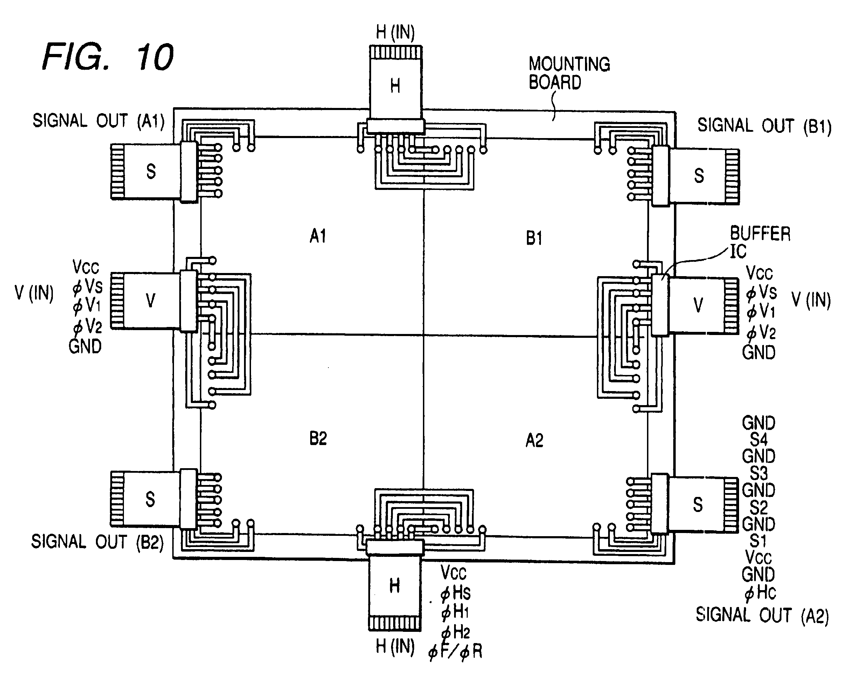

Further, the four image pickup sensors can be operated by a common driving pulse so that a peripheral driving pulse generating circuit can be easily operated. An image pickup sensor driving circuit can be also commonized by performing the common driving operation as described in a mounting construction of Fig. 10. Accordingly, it should be understood that this construction is excellent in mounting.

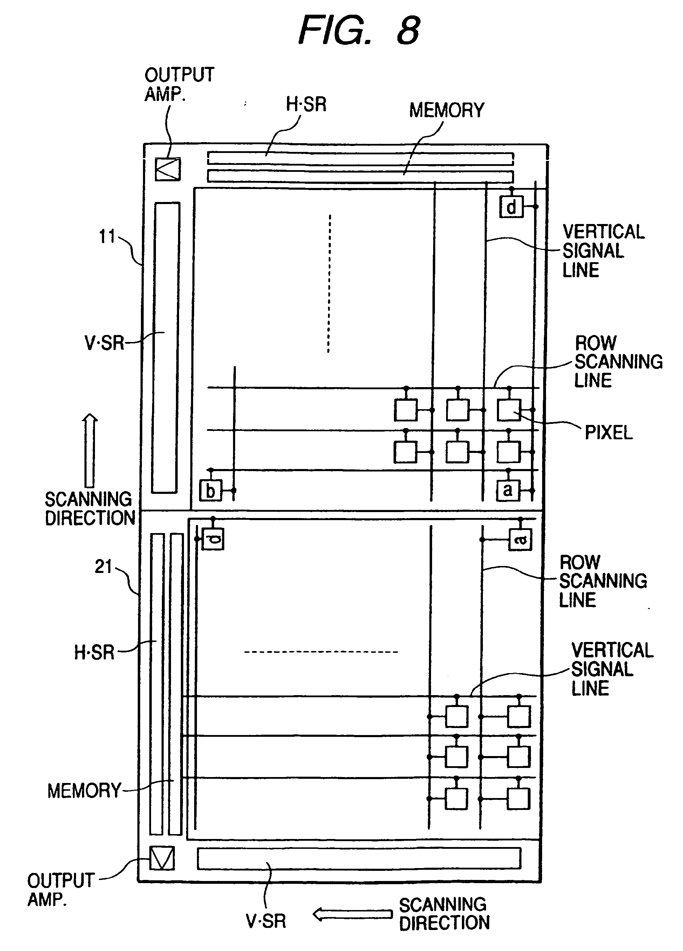

For comparison, Fig. 8 shows a conceptual view in which upper and lower (left-hand and right-hand) sensors are formed in the same form. In Fig. 8, a row scanning operation of an image pickup sensor 11 is performed from below to above in Fig. 8 and the scanning operation of an image pickup sensor 21 is performed from rightward to leftward in Fig. 8. When changes in exposure time at such a row scanning time are compared, the exposure times of the image pickup sensors 11 and 21 are conformed to each other with respect to only a pixel a located at a diagonal angle of the image pickup sensors. With respect to a pixel b of the image pickup sensor 11 and a pixel d of the image pickup sensor 21, a shift in exposure timing of a one field period is caused. However, the exposure times of the image pickup sensors located in the vicinity of a sticking face can be conformed to each other by forming diagonal image pickup sensors in the same form as shown in Figs. 1 and 2, in other words, by combining the row scanning circuit with a sensor constructed by mirror inversion. Accordingly, no unnaturalness of a motion image is caused at a sensing time of the motion image.

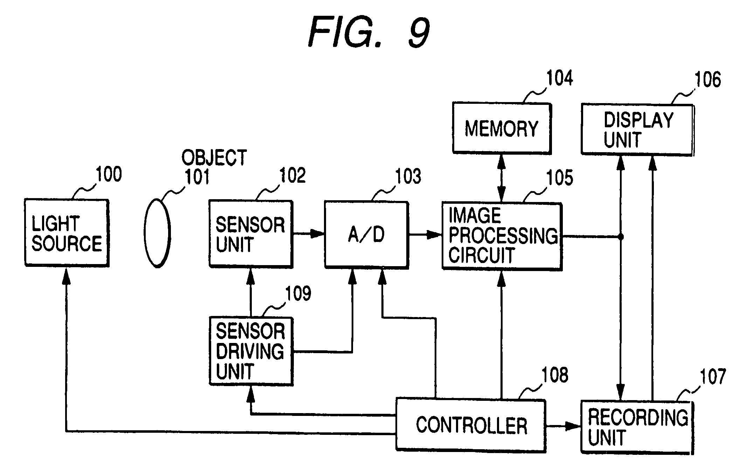

Fig. 9 is a view showing one embodiment of an entire construction of the image pickup apparatus. The image of an object (a chest portion of a human being) 101 is picked up by a radiant ray from a light source (X-ray) 100. A sensor unit 102 is constructed by the image pickup sensor of Fig. 2, a phosphor for converting the radiant ray to a visible ray, an X-ray shield member and a peripheral driving circuit.

A signal of 4 × 8 systems (a signal outputted by an 8-output line from four image pickup sensors) from the sensor unit 102 is converted by an A/D converter 103 from an analog signal to a digital signal. A sensor driving unit 109 is mounted such that this sensor driving unit 109 is adjacent to the sensor unit 102.

With respect to the A/D converted signal, synthesis of four image signals, the correction of a pixel defective noise, etc. are made by an image processing circuit 105 and a memory 104. This processing signal is stored to a recording unit 107, or is displayed in a display unit (monitor) 106, and is printed in accordance with necessity. Operations of these circuits and respective devices are entirely controlled by a controller 108.

Fig. 10 is a typical constructional view showing a mounting example of the image pickup apparatus of this embodiment. In Fig. 10, reference characters A1, B1, B2 and A2 denote image pickup areas described with reference to Figs. 1 and 2, and four image pickup sensors having the respective image pickup areas are stuck to each other on a mounting board. The mounting board is constructed by glass, a fiber plate, etc. Wirings for a driving pulse of the sensors, a power source, signals and joint to a GND terminal are formed on the mounting board. A wiring pattern is formed by a transparent member (e.g., ITO), an aluminum member, etc. In the case of the aluminum member, a pattern wiring is formed so as to avoid a light receiving portion of pixels.

In a row driving operation of each of the image pickup sensors, power source Vcc and driving pulses φVs, φV1, φV2, GND are supplied from an illustrated V-flexible board.

In a column driving operation, power source Vcc and driving pulses φHs, φH1, φH2, φF/φR are supplied from an illustrated H-flexible board.

Row and column driving systems of this image pickup sensor are arranged in the vicinity of sticking sides. Therefore, as shown in Fig. 10, the driving systems of adjacent image pickup sensors are easily connected to a common flexible board and a buffer IC. Accordingly, the number of external inputs can be reduced.

A signal output of the image pickup sensor of this embodiment is transmitted to a flexible board S. Output signals S1, S2, S3, S4 are transmitted between GND lines. Power source Vcc of an output amplifier and a reset pulse on an output signal line are also supplied from the flexible board S. A buffer amplifier on the flexible board S may be also arranged on the mounting board. An A/D converter may be also used instead of the buffer amplifier. Here, if analog-digital conversion is performed, generation of noises is reduced and S/N is improved.

In this embodiment, if face-down mounting is performed, sticking mounting of the four image pickup sensors and wiring joint can be performed on the same board so that cost can be reduced and a face step difference of each image pickup sensor can be reduced as merits.

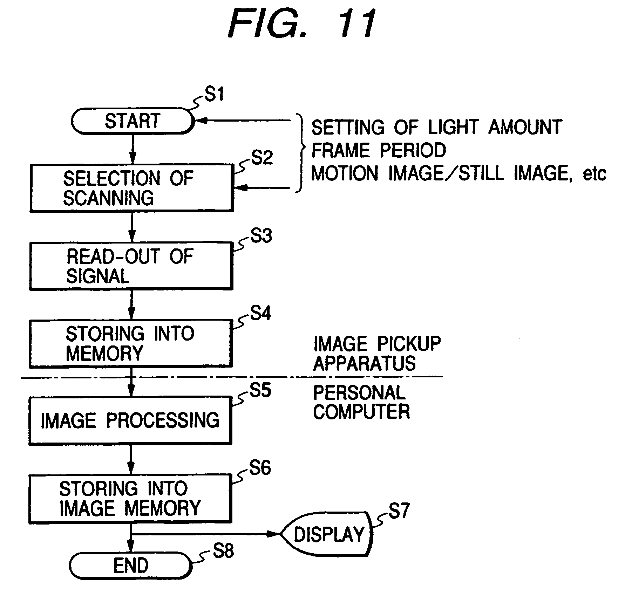

Fig. 11 shows a schematic flow of taking-in of data from rising setting of the apparatus, and processing and display of the data. After the rising of a power source, image sensing is started (S1). At a starting time, a light amount of an X-ray, an image sensing period (frame period) and a image sensing condition are inputted to an input device (a keyboard, etc.) of a personal computer, etc., and a selection of scanning is set (S2). In particular, in the case of a motion image, a scanning direction is set as mentioned above. Object information is accumulated to a sensor and read-out of a signal is sequentially performed (S3). A signal read out of each image pickup sensor is temporarily stored to an accumulating memory (S4).

Image processing (y processing, interpolating processing, etc.) for synthesizing each sensor signal as one image is performed with respect to the memory signal temporarily stored to the accumulating memory (S5). This output is stored into a large-sized image memory (S6) and a memory output is displayed (S7) in a monitor, etc. When the image sensing is terminated, the operation of the image pickup apparatus is ended (S8). Data inputted to the image pickup apparatus are transferred to a personal computer, etc. and software processing, etc. for analyzing the object is performed in this personal computer, etc.

The above image processing method can be executed on the basis of a program stored to a computer such as a personal computer. The present invention also includes an information recording medium such as a CD-ROM for recording such a program thereto. The image processing method according to the present invention can be executed by reading the program recorded to the CD-ROM, etc.

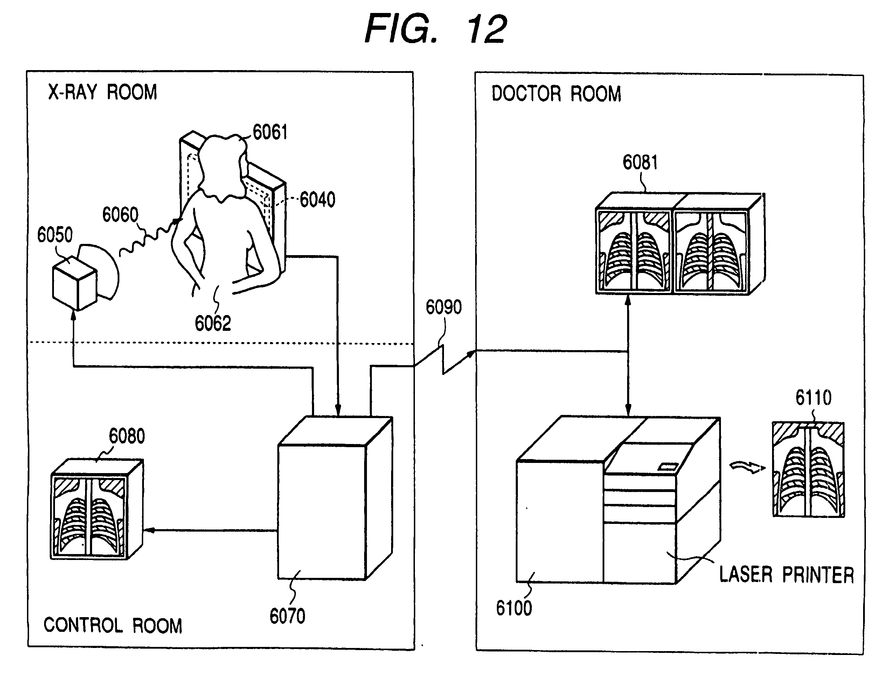

Fig. 12 is a typical view showing a further concrete example of an image processing system (an X-ray diagnostic system) using the image pickup apparatus in this embodiment.

An X-ray 6060 generated in an X-ray tube 6050 is transmitted through a chest portion 6062 of a patient or a tested person 6061 and is incident to an image pickup apparatus 6040 mounting a scintillator to its upper portion according to the present invention. This incident X-ray includes information as to inside of the body of the patient 6061. The scintillator emits light in accordance with the incidence of the X-ray and photoelectrically converts this light and obtains electric information. This information is digitally converted and is image-processed by an image processor 6070 and can be observed by a display 6080 in a control room.

This information can be transferred to a remote place by a transfer means such as a telephone line 6090, and can be displayed in a display 6081 in a doctor room, etc. in a separate place. Otherwise, this information can be stored to a storing means such as an optical disk. Accordingly, a doctor in the remote place can diagnose the patient. Further, this information can be recorded to a film 6110 by a film processor 6100.

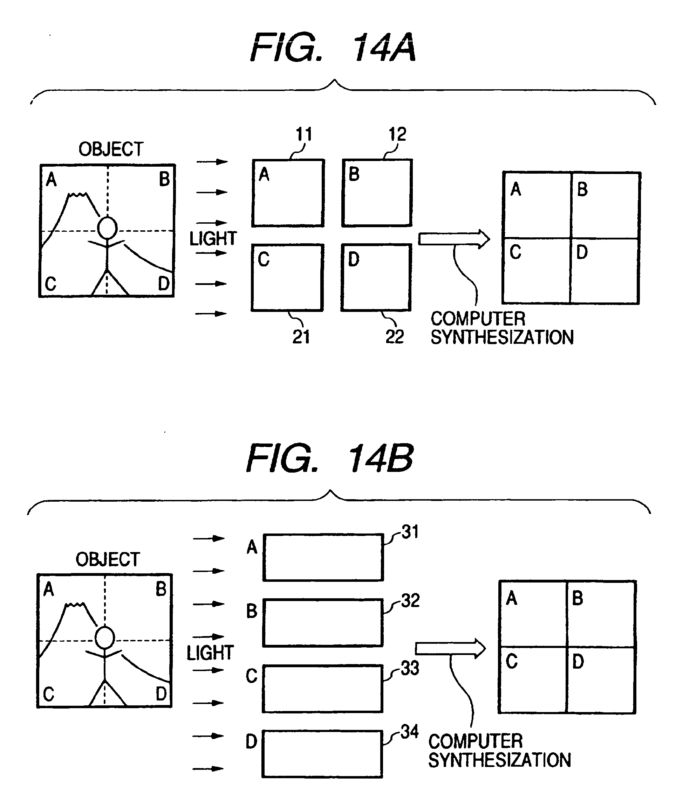

Here, the plural image pickup areas described in this embodiment are not limited to a structure in which the plural image pickup areas are formed on one semiconductor board. Namely, the image pickup areas are respectively divided into IC packages, and a signal from an object such as a landscape, a human being is divided into the image pickup areas within the respective IC packages and light is received so that an image of the object is finally formed. In this case, accumulating timings of adjacent pixels between adjacent image pickup areas may be set to be equal to each other. Fig. 14A is an explanatory view showing this situation. As shown in Fig. 14A, the object image is divided into four images A, B, C and D and is set such that these images are picked up by IC packages 11, 12, 21 and 22 having the respective image pickup areas. In this case, no IC packages are necessarily closely stuck to each other. For example, it is sufficient to divide an optical signal from the object by a different optical system and make the divided optical signals incident to the image pickup areas of the respective IC packages.

Further, it is not necessary to arrange the respective image pickup areas within the IC packages. For example, the image pickup areas may be divided by a device such as a video camera, and may receive optical signals from the object. Fig. 14B shows this situation. As shown in Fig. 14B, the object image is divided into four images A, B, C and D and these images are respectively picked up by video cameras 31 to 34. For example, the scanning directions of pixel columns in image pickup areas within video cameras 31 and 33 are set to be opposed to each other.

It is not necessary to arrange the light receiving image pickup areas in accordance with the object image when the object image is divided on the light receiving image pickup areas which receive light from the object. The image pickup areas themselves may be arranged in any way if images are finally synthesized and processed by a computer, etc. and the synthesized images construct the object image.

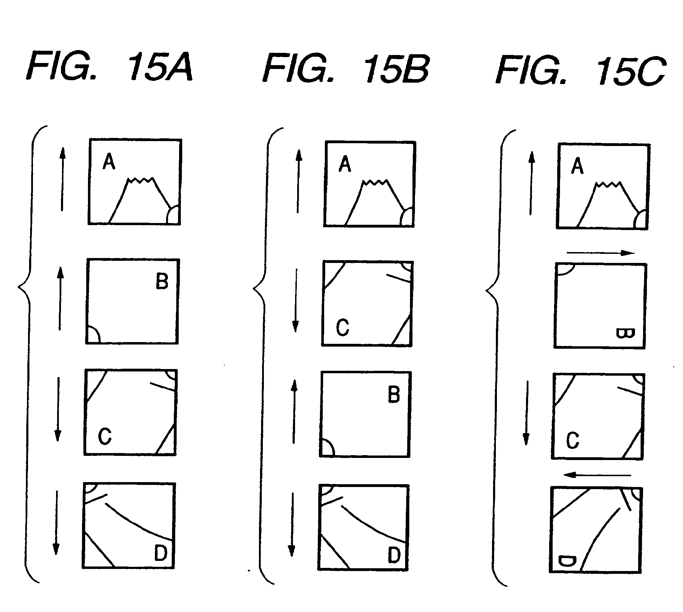

For example, when the case of Fig. 14B is explained by using Figs. 15A to 15C, it is sufficient to set finally synthesized images to be equal to the object image even in any arrangement of Figs. 15A to 15C. Further, it is not necessary to arrange the image pickup areas in a column (or matrix) shape. An arrow of each of Figs. 15A to 15C shows an orientation of the scanning direction and it is sufficient to set the scanning directions to be opposed to each other with respect to a dividing line of the object.

The following effects can be obtained in accordance with the embodiments.
(1). A motion image of high quality can be picked up since image pickup exposure time for each of image pickup areas opposed to each other in sticking can be approximately set to the same time.
(2). Since plural image pickup sensors can be constructed by sensors of the same kind, processes until sensor unit manufacture are simplified and the image pickup sensors can be easily manufactured so that cost can be reduced.
(3). Since the plural image pickup sensors can be operated by a common driving pulse, the number of peripheral driving circuits can be reduced and the peripheral driving circuits can be simply mounted so that power consumption, noises and cost are reduced.
(4). Since an X-ray image pickup apparatus can be constructed by a high sensitivity sensor, an X-ray irradiating amount can be considerably reduced so that the X-ray image pickup apparatus becomes safer for the human body.

Many widely different embodiments of the present invention may be constructed without departing from the scope of the present invention. It should be understood that the present invention is not limited to the specific embodiments described in the specification, except as defined in the appended claims.

## Claims

1. An image pickup apparatus comprising:
image pickup areas (A1,B1,A2,B2) arranged two-dimensionally in a first direction and a second direction, different from the first direction, on respective semiconductor substrates, each of said image pickup areas including pixels (100: 10-50) arranged in the first direction and in the second direction wherein image pickup areas (A1, B1, A2, B2) in which the pixels are connected to each vertical signal line (60) on the unit basis of a plurality of pixels arranged in the first direction, and each of said pixels (100:10-50) including a photodiode (10) and a pixel amplifier (40) for holding a signal from the photodiode (10) at a floating diffusion portion of the pixel amplifier (40) and amplifying the signal;
first scanning circuits (2 : V-SR), arranged to reset-scan the floating diffusion portion of the pixel amplifier (40) on a unit basis of the plurality of pixels (100:10-50) arranged in the second direction and read-scan the pixels (100:10-50) so as to read out signals to the vertical signal lines (60) on the unit basis of the plurality of pixels (100:10-50) arranged in the second direction, wherein said first scanning circuits (2:V-SR) effect in parallel the reset scanning and read scanning of each plurality of image pickup areas (A1,B1, A2,B2) arranged in the first direction;
a memory circuit (3: C_{τs}, C_{τN},.....) , arranged to hold signals from one line of pixels arranged in the second direction; and
second scanning circuits (1: H-SR) arranged to sequentially read out the signals held in said memory circuit (3:Cτn,...) to an output line, wherein said second scanning circuits (1:H-SR) scan in parallel the plurality of image pickup areas (A1.B1, A2,B2) arranged in the second direction, to read out the signals held in said memory circuit; wherein:
said first scanning circuit (2:V-SR) is arranged so as to reset-scan the image pickup areas (A1, B2, B1, A2) on the respective semiconductor substrates which are arranged adjacently to each other in the first direction, in opposite directions to reset the floating diffusion portion of the pixel amplifier (40) of the pixels (100-10-50) included therein, and read-scan the image pickup areas (A1,B1,A2,B2) on the respective semiconductor substrates, which are arranged adjacently to each other in the first direction, in opposite directions to read out the pixels (100:10-50) included therein.

2. An image pickup apparatus according to claim 1, wherein said second scanning circuits (1: H-SR) scan the image pickup areas (A1 & B1, A2 & B2) adjacent to each other in the second direction, in same directions, respectively.

3. An image pickup apparatus according to claim 1, wherein said image pickup areas (A1-B2) are included in a plurality of image pickup sensor boards (11, 12, 21 & 22) which are stuck to each other, each of said image pickup sensor boards including a respective plurality of pixels and said first and second scanning circuits (2, 1), and
wherein two image sensor boards adjacent to each other are arranged so that one of the two image sensor boards inputs a predetermined drive pulse for driving said first and second scanning circuits and supplies the predetermined drive pulse to the other of said two image pickup sensor boards.

4. An image pickup apparatus according to claim 1, wherein said image pickup areas (a1-B2) are included in a plurality of image pickup sensor boards (11, 12, 21 & 22) which are stuck to each other, each of said plurality of image pickup sensor boards including a plurality of pixels and said first and second scanning circuits (2, 1); and
a common flexible board (H;V) wherein it is arranged that a predetermined drive pulse for driving said first or second scanning circuits (2,1) included in each of two image pickup sensor boards adjacent to each other is input from said common flexible board.

5. An image pickup apparatus according to any one of claims 1 to 4, further comprising:
an A-D conversion circuit (103), which converts the signal from the pixels into digital signals;
an image processing circuit (105), which image-processes the signals from said A/D conversion circuit; and
a display unit (106), which displays an object to be picked up.

6. An image pickup apparatus according to any one of claims 1 to 5, further comprising a radiation generation source (6050), which generates radiation (6060), and a scintillator arranged on said apparatus, wherein it is arranged that radiation generated by said radiation generation source can enter said scintillator via an object (6062).

## Patentansprüche

1. Bildaufnahmegerät, umfassend:
Bildaufnahmebereiche (A1, B1, A2, B2), die zweidimensional in einer ersten Richtung und in einer zu der ersten Richtung unterschiedlichen zweiten Richtung auf jeweiligen Halbleitersubstraten angeordnet sind, wobei jeder der Bildaufnahmebereiche Pixel (100: 10-50) beinhaltet, die in der ersten Richtung und in der zweiten Richtung angeordnet sind, und wobei in den Bildaufnahmebereichen (A1, B1, A2, B2) die Pixel mit jeder vertikalen Signalleitung (60) auf der Einheitsbasis einer Vielzahl von in der ersten Richtung angeordneten Pixeln verschaltet sind, und jedes der Pixel (100: 10-50) eine Fotodiode (10) und einen Pixelverstärker (40) zum Halten eines Signals von der Fotodiode (10) an einem potenzialfreien Diffusionsabschnitt des Pixelverstärkers (40) und Verstärken des Signals einschließt;
erste Abtastschaltkreise (2: V-SR), die dazu angeordnet sind, den potenzialfreien Diffusionsabschnitt des Pixelverstärkers (40) auf einer Einheitsbasis der Vielzahl von Pixeln (100: 10-50), die in der zweiten Richtung angeordnet sind, zurücksetzend abzutasten und die Pixel (100: 10-50) lesend abzutasten, um die Signale auf die vertikalen Signalleitungen (60) auf der Einheitsbasis der Vielzahl von in der zweiten Richtung angeordneten Pixeln (100: 10-50) auszulesen, wobei die ersten Abtastschaltkreise (2: V-SR) parallel die rücksetzende Abtastung und die lesende Abtastung jedes der Vielzahl von Bildaufnahmebereichen (A1, B1, A2, B2), die in der ersten Richtung angeordnet sind, bewirken;
eine Speicherschaltung (3: C_{TS}, C_{TN}, ...), die dazu angeordnet ist, Signale von einer Zeile von in der zweiten Richtung angeordneten Pixeln zu halten;
zweite Abtastschaltkreise (1: H-SR), die dazu angeordnet sind, die in der Speicherschaltung (3: C_{Tn}, ...) gehaltenen Signale sequentiell auf eine Ausgangsleitung auszulesen, wobei die zweiten Abtastschaltkreise (1: H-SR) parallel die Vielzahl von Bildaufnahmebereichen (A1, B1, A2, B2), die in der zweiten Richtung angeordnet sind, abtasten, um die in der Speicherschaltung gehaltenen Signale auszulesen; wobei:
der erste Abtastschaltkreis (2: V-SR) dazu angeordnet ist, die Bildaufnahmebereiche (A1, B2, B1, A2) auf den jeweiligen Halbleitersubstraten, welche in der ersten Richtung benachbart zueinander angeordnet sind, in entgegen gesetzten Richtungen zurücksetzend zu lesen, um den potenzialfreien Diffusionsabschnitt des Pixelverstärkers (40) der darin eingeschlossenen Pixel (100-10-50) zurück zu setzen und die Bildaufnahmebereiche (A1, B1, A2, B2) auf den jeweiligen Halbleitersubstraten, welche zu einander benachbart in der ersten Richtung angeordnet sind, in entgegen gesetzten Richtungen lesend abzutasten, um die darin eingeschlossenen Pixel (100: 10-50) auszulesen.

2. Bildaufnahmegerät nach Anspruch 1, bei dem die zweiten Abtastschaltkreise (1: H-SR) die in der zweiten Richtung zu einander benachbarten Bildaufnahmebereiche (A1 & B1, A2 & B2) jeweils in gleichen Richtungen abtasten.

3. Bildaufnahmegerät nach Anspruch 1, bei dem die Bildaufnahmebereiche (A1-B2) in einer Vielzahl von Bildaufnahmesensorplatinen (11, 12, 21 & 22) eingeschlossen sind, welche an einander befestigt sind, wobei jede der Bildaufnahmesensorplatinen eine jeweilige Vielzahl von Pixeln und den ersten und den zweiten Abtastschaltkreis (2, 1) einschließt, und
bei dem zwei zu einander benachbarte Bildsensorplatinen derart angeordnet sind, dass eine der beiden Bildsensorplatinen einen vorbestimmten Ansteuerimpuls zum Ansteuern des ersten und des zweiten Abtastschaltkreises aufnimmt und den vorbestimmten Ansteuerimpuls an die andere der beiden Bildaufnahmesensorplatinen liefert.

4. Bildaufnahmegerät nach Anspruch 1, bei dem die Bildaufnahmebereiche (a1-B2) in einer Vielzahl von Bildaufnahmesensorplatinen (11, 12, 21 & 22), welche an einander befestigt sind, eingeschlossen sind, wobei jede der Vielzahl von Bildaufnahmesensorplatinen eine Vielzahl von Pixeln und den ersten und den zweiten Abtastschaltkreis (2, 1) einschließt; und
eine gemeinsame flexible Platine (H; V), in der eine Anordnung derart getroffen ist, dass ein vorbestimmter Ansteuerimpuls zum Ansteuern des ersten oder des zweiten Abtastschaltkreises (2, 1), die in jeder von zwei zu einander benachbarten Bildaufnahmesensorplatinen enthalten sind, von der gemeinsamen flexiblen Platine zugeführt wird.

5. Bildaufnahmegerät nach einem der Ansprüche 1 bis 4, ferner umfassend:
eine A-D-Umwandlungsschaltung (103), welche das Signal von den Pixeln in digitale Signale umwandelt;
eine Bildverarbeitungsschaltung (105), welche die Signale von der A/D-Umwandlungsschaltung bildverarbeitet; und
eine Anzeigeeinheit (106), welche ein aufzunehmendes Objekt anzeigt.

6. Bildaufnahmegerät nach einem der Ansprüche 1 bis 5, ferner umfassend eine Strahlungserzeugungsquelle (6050), welche Strahlung (6060) erzeugt, und einen an dem Gerät angeordneten Szintillator, wobei eine Anordnung derart getroffen ist, dass von der Strahlungserzeugungsquelle erzeugte Strahlung über ein Objekt (6062) in den Szintillator eintreten kann.

## Revendications

1. Appareil de saisie d'image comportant :
des zones (A1, B1, A2, B2) de saisie d'image agencées en deux dimensions dans une première direction et une seconde direction différente de la première direction, sur des substrats semiconducteurs respectifs, chacune desdites zones de saisie d'image comprenant des pixels (100 : 10-50) agencés dans la première direction et dans la seconde direction, dans lequel des zones de saisie d'image (A1, B1, A2, B2) dans lesquelles les pixels sont connectés à chaque ligne verticale de signal (60) sur la base unité de plusieurs pixels agencés dans la première direction, et chacun desdits pixels (100 : 10-50) comprenant une photodiode (10) et un amplificateur (40) de pixel pour bloquer un signal provenant de la photodiode (10) à une partie de diffusion flottante de l'amplificateur de pixel (40) et amplifier le signal ;
des premiers circuits de balayage (2 : V-SR), agencés de façon à restaurer-balayer la partie de diffusion flottante de l'amplificateur de pixel (40) sur une base unité de la pluralité de pixels (100 : 10-50) agencés dans la seconde direction, et à lire-balayer les pixels (100 : 10-50) de façon à extraire des signaux vers les lignes verticales de signaux (60) sur la base unité de la pluralité de pixels (100 : 10-50) agencés dans la seconde direction, dans lequel lesdits premiers circuits de balayage (2 : V-SR) effectuent en parallèle le balayage de restauration et le balayage de lecture de chacune de la pluralité de zones (A1, B1, A2, B2) de saisie d'image agencées dans la première direction ;
un circuit de mémoire (3 : C_{τS}, C_{τN}, ...), agencé de façon à bloquer des signaux provenant d'une ligne de pixels agencés dans la seconde direction ; et
des seconds circuits de balayage (1 : H-SR) agencés de façon à extraire séquentiellement les signaux bloqués dans ledit circuit de mémoire (3 : Cτn, ...) vers une ligne de sortie, lesdits seconds circuits de balayage (1 : H-SR) balayant en parallèle la pluralité de zones (A1, B1, A2, B2) de saisie d'image agencées dans la seconde direction, afin d'extraire les signaux bloqués dans le circuit de mémoire ; dans lequel :
ledit premier circuit de balayage (2 : V-SR) est agencé de façon à restaurer-balayer les zones (A1, B2, B1, A2) de saisie d'image sur les substrats semiconducteurs respectifs qui sont agencées de façon à être adjacentes les unes aux autres dans la première direction, dans des sens opposés afin de restaurer la partie de diffusion flottante de l'amplificateur de pixel (40) des pixels (100-10-50) qui y sont inclus, et à lire-balayer les zones (A1, B1, A2, B2) de saisie d'image sur les substrats semiconducteurs respectifs, qui sont agencées de façon à être adjacentes les unes aux autres dans la première direction, dans des sens opposés afin d'extraire les pixels (100 : 10-50) qui y sont inclus.

2. Appareil de saisie d'image selon la revendication 1, dans lequel lesdits seconds circuits de balayage (1 : H-SR) balaient les zones de saisie d'image (A1 et B1, A2 et B2) adjacentes les unes aux autres dans la seconde direction, dans les mêmes sens, respectivement.

3. Appareil de saisie d'image selon la revendication 1, dans lequel lesdites zones (A1-B2) de saisie d'images sont incluses dans une pluralité de plaquettes (11, 12, 21 et 22) de capteur de saisie d'image qui sont collées les unes aux autres, chacune desdites plaquettes de capteur de saisie d'image comprenant une pluralité respective de pixels et lesdits premiers et seconds circuits de balayage (2, 1), et
dans lequel deux plaquettes de capteur d'image adjacentes l'une à l'autre sont agencées de façon que l'une des deux plaquettes de capteur d'image applique en entrée une impulsion d'attaque prédéterminée pour attaquer lesdits premiers et seconds circuits de balayage et fournisse une impulsion d'attaque prédéterminée à l'autre desdites deux plaquettes de capteur de saisie d'image.

4. Appareil de saisie d'image selon la revendication 1, dans lequel lesdites zones (A1-B2) de saisie d'image sont incluses dans une pluralité de plaquettes (11, 12, 21 et 22) de capteur de saisie d'image qui sont collées les unes aux autres, chacune de ladite pluralité de plaquettes de capteur de saisie d'image comprenant une pluralité de pixels et lesdits premiers et seconds circuits de balayage (2, 1) ; et
une plaquette souple commune (H ; V) dans laquelle l'agencement est tel qu'une impulsion d'attaque prédéterminée pour attaquer lesdits premiers ou seconds circuits de balayage (2, 1) inclus dans chacune de deux plaquettes de capteur de saisie d'image adjacentes l'une à l'autre soit appliquée en entrée depuis ladite plaquette souple commune.

5. Appareil de saisie d'image selon l'une quelconque des revendications 1 à 4, comportant en outre :
un circuit de conversion A-N (103) qui convertit le signal provenant des pixels en signaux numériques ;
un circuit (105) de traitement d'image qui soumet à un traitement d'image les signaux provenant dudit circuit de conversion A/N ; et
une unité d'affichage (106) qui affiche un objet devant être saisi.

6. Appareil de saisie d'image selon l'une quelconque des revendications 1 à 5, comportant en outre une source (6050) de génération de rayonnement qui génère un rayonnement (6060), et un scintillateur agencé sur ledit appareil, l'agencement étant tel qu'un rayonnement généré par ladite source de génération de rayonnement peut entrer dans ledit scintillateur en passant par un objet (6062).
